# EUROPEAN PATENT APPLICATION

(11) **EP 0 899 746 A2**
(43) Date of publication of application: **03.03.1999**
(21) Application number: 98306505.3
(22) Date of filing: 14.08.1998
(51) Int. Cl.: G11C 27/00

(54) **Single message multilevel analog signal recording and playback system**

(30) Priority: 18.08.1997 US 912590
(71) Applicant: INFORMATION STORAGE DEVICES, INC., San Jose, CA 95125 (US)
(72) Inventor: Engh, Lawrence D., Redwood City, California 94062 (US); Hoei, Jung Sheng, Newark, California 94560 (US); Lee, May, San Jose, California 95124 (US); Nazarian, Hagop, San Jose, California 95117 (US); Sowards, David, Fremont, California 94539 (US)
(74) Representative: Wombwell, Francis

(57) **Abstract**

This invention discloses an integrated circuit for processing an audio signal of a message. The integrated circuit comprises a record circuit, an analog storage circuit, and a playback circuit. The record circuit is coupled to receive the audio signal and generates a filtered signal. The analog storage circuit is AC-coupled to the record circuit for storing the filtered signal. The playback circuit is coupled to the analog storage circuit for retrieving a stored signal in the storage circuit.

## Description

### BACKGROUND OF THE INVENTION

### 1. FIELD OF THE INVENTION

The present invention generally relates to analog signal processing. In particular, the present invention relates to a single integrated circuit for analog signal recording and playback.

### 2. DESCRIPTION OF RELATED ART

Multilevel analog signal recording and playback devices have found numerous applications in signal processing requiring low power and compactness. In these applications, analog techniques are preferable to digital techniques because a complete single-chip solution is possible with analog integrated circuits.

One prior art single chip device for analog signal recording and playback is the ISD1400 series manufactured by Information Storage Devices at San Jose, California. There is a need in the analog signal recording and playback technology to provide a highly integrated device to implement many functions on chip to reduce the number of pins and eliminate external circuitry while also reducing space.

### SUMMARY OF THE INVENTION

This invention discloses an integrated circuit for processing an audio signal of a message. The integrated circuit comprises a record circuit, an analog storage circuit, and a playback circuit. The record circuit is coupled to receive the audio signal and generates a filtered signal. The analog storage circuit is AC-coupled to the record circuit for storing the filtered signal. The playback circuit is coupled to the analog storage circuit for retrieving a stored signal in the storage circuit.

### BRIEF DESCRIPTION OF THE DRAWINGS

The advantages of the present invention will become more readily apparent to those ordinarily skilled in the art after reviewing the following detailed description and accompanying drawings, wherein:

Figure 1 is a block diagram illustrating one embodiment of the present invention.

Figure 2(A) is a block diagram illustrating one embodiment of the pre-amplifier stage in accordance to the teaching of the present invention.

Figure 2(B) is a block diagram illustrating one embodiment of the automatic gain control in accordance to the teaching of the present invention.

Figure 3(A) is a circuit diagram illustrating the conceptual design of one embodiment of the amplifier stage.

Figure 3(B) is a circuit diagram illustrating the design of the embodiment shown in Figure 3(A).

Figure 4 is a block diagram illustrating one embodiment of the analog transceiver.

Figure 5 is a block diagram illustrating one embodiment of the voltage ramp amplitude controller.

Figure 6 is a block diagram illustrating one embodiment of the charge pump for programming the storage array.

Figure 7 is a block diagram illustrating one embodiment of the adaptive ramp amplitude controller.

Figure 8 is a block diagram illustrating one embodiment of the end of message markers.

Figure 9 is a block diagram illustrating one embodiment of the disabling controller.

### DETAILED DESCRIPTION OF THE INVENTION

The present invention discloses a single-chip, single-message voice record and playback device. The device is highly integrated with on-chip implementation of many functions. The present invention offers single-chip solution in applications requiring compactness, flexibility, and low power consumption.

In the following description, for purposes of explanation, numerous details are set forth in order to provide a thorough understanding of the present invention. However, it will be apparent to one skilled in the art that these specific details are not required in order to practice the present invention. In other instances, well known electrical structures and circuits are shown in block diagram form in order not to obscure the present invention unnecessarily.

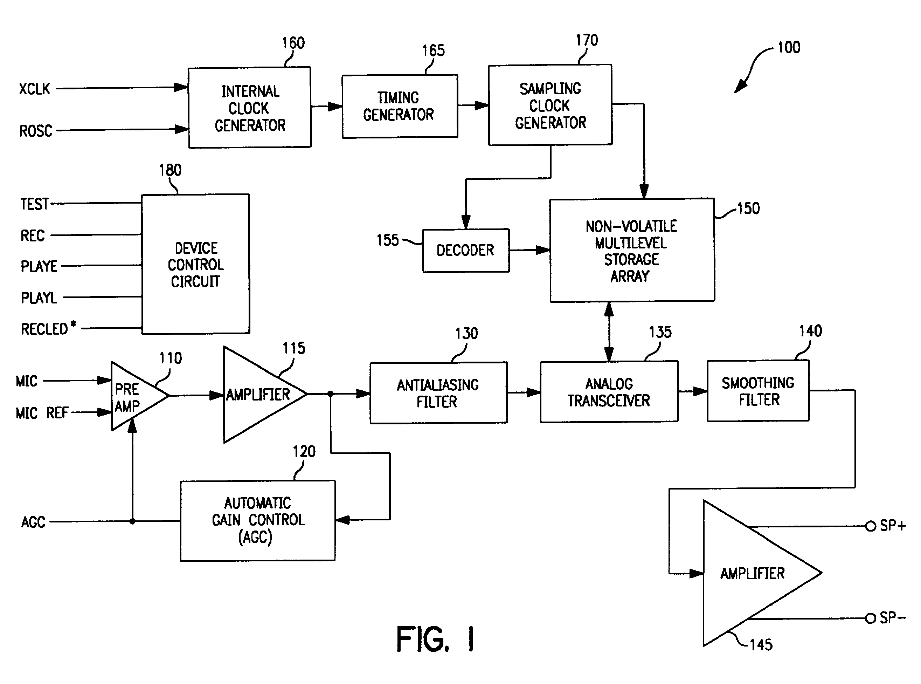

Referring to Figure 1, a block diagram illustrating one embodiment of the integrated voice circuit system in accordance to the teaching of the present invention is shown. The integrated voice circuit system 100 consists of a pre-amplifier 110, an amplifier 115, an automatic gain control (AGC) circuit 120, an anti-aliasing filter 130, an analog transceiver 135, a smoothing filter 140, an output amplifier 145, a non-volatile multilevel storage array 150, a decoder 155, an internal clock generator 160, a timing generator 165, a sampling clock generator 170, and a device control circuit 180.

The inputs to the device include the microphone input (MIC), microphone reference (MIC REF), automatic gain control (AGC), edge-activated playback (PLAYE), level-activated playback (PLAYL), record (REC), external clock (XCLK), test (TEST), resistor controlled oscillator (ROSC), and power supply inputs. The outputs from the device include the speaker outputs (SP+ and SP-), and record LED output (RECLED*).

There are two distinct paths on the integrated voice circuit system 100: a record path and a playback path. The record path is for recording or writing or storing the voice signal into the non-volatile multi-level storage array 150. The playback path is for playing back, or reading, or retrieving the voice signals from the non-volatile multi-level storage array 150 and output to the speaker.

The record path comprises the pre-amplifier 110, the amplifier 115, the AGC circuit 120, the anti-aliasing filter 130, the analog transceiver 135, and the non-volatile multi-level storage array 150.

The playback path comprises the non-volatile multi-level storage array 150, the analog transceiver 135, the smoothing filter 140, and the output amplifier 145. These elements participate in the reconstructing of the message.

Pre-amplifier 110 amplifies the input signal from the MIC inputs. The pre-amplifier output signal is AC coupled to the second stage amplification provided by amplifier 115. The output of the amplifier 115 is fed back through the AGC circuit 120 to adjust the gain of the pre-amplifier 110 to maintain signal quality.

The anti-aliasing filter 130 provides filtering function to eliminate unwanted high frequency noise which is above the voice frequency range. The analog transceiver 135 transfers the analog signal to be stored in storage array 150. The analog transceiver 135 also retrieves the analog signal from storage array 150 to be read out and AC couples it to the smoothing filter 140. The analog transceiver 135 is described in more details later. The smoothing filter 140 provides additional filtering. The output amplifier 145 amplifies the smoothed analog signal to drive the speaker outputs SP+ and SP-.

The non-volatile multilevel storage array 150 consists of a number of memory cells to store the analog signal. The decoder 155 provides the addressing function to the storage array 150.

The internal clock generator 160 receives the XCLK and ROSC inputs to generate clock signals used internally. The timing generator 165 receives the clock signal as generated by the internal clock generator 160 to provide additional timing signals to be used in many internal control circuits. The sampling clock generator 170 provides the sampling clock signal to the storage array 150 and its associated circuitry. The device control circuit 180 receives control inputs such as REC, PLAYE, PLAYL and generates a number of control signals to various circuits and the devices outputs such as the RECLED* output.

The XCLK input provides a clock input for testing purposes. The ROSC input provide a means to vary the internal clock frequency. This internal clock frequency depends on the value of the resistor connected from the ROSC input to ground. Changing this resistor value changes the frequency of the internal clock which in turn changes the timing generator and sampling clock generator accordingly.

These changes in clock frequencies change the duration of the recording and the playback. Accordingly, by varying the resistor value at the ROSC input, a multi-duration for message recording and playback is realized. Since recording and playback are two independent processes, this multi-duration configuration can be applied to the record path and the playback path independently. In other words, the recording of a message can be performed with one value of resistor and the playback of a message can be done with another resistor value or a variable resistor.

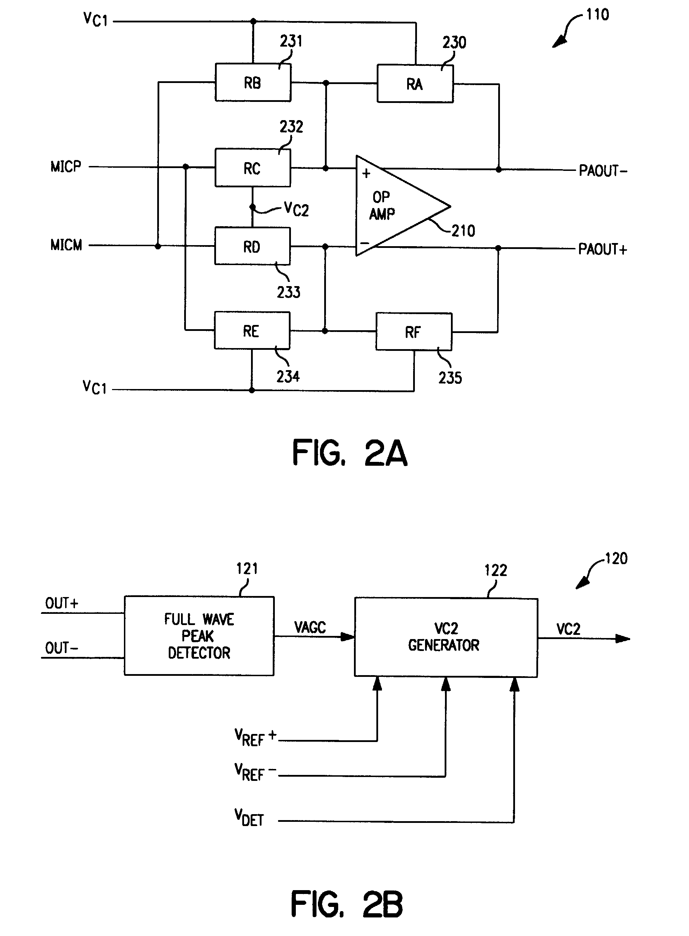

Referring to Figure 2(A), a block diagram illustrating one embodiment of the pre-amplifier stage in accordance to the teaching of the present invention is shown. The pre-amplifier 110 consists of operational amplifier (op amp) 210, voltage controlled MOS resistors RA 230, RB 231, RC 232, RD 233, RE 234, and RF 235. The inputs to the pre-amplifier 110 are the MICP and MICM having voltage values of VMICP and VMICM, respectively. The outputs of the pre-amplifier 110 are the PAOUT- and PAOUT+.

The voltage controlled resistors RA 230, RB 231, RE 234, and RF 235 have fixed values set by the constant voltage VC1. The voltage controlled resistors RC 232 and RD 233 have variable values determined by variable voltage VC2. Using voltage controlled resistors provide a wide dynamic range for the inputs while reducing signal distortion. In addition, the maximum gain is a well controlled parameter because the signal gain is controlled by the ratio of the resistor values.

Referring to Figure 2(B), a block diagram illustrating one embodiment of the automatic gain control in accordance to the teaching of the present invention is shown. The automatic gain control (AGC) circuit 120 consists of full-wave peak detector 121 and VC2 generator 122. The inputs to the AGC circuit 120 are the two outputs of the second stage amplifier 115, OUT+ and OUT-. The output of the AGC circuit 120 is the variable voltage VC2 used in the pre-amplifier 110.

The full-wave peak detector 121 has a faster response time than the half-wave detector and provides a lower ripple output. The VC2 generator 122 receives the reference voltages VREF+ and VREF- and a constant voltage VDET. The VC2 generator monitors the change in the VAGC value by comparing the VAGC with the reference voltages VDET and produces the VC2 voltage accordingly.

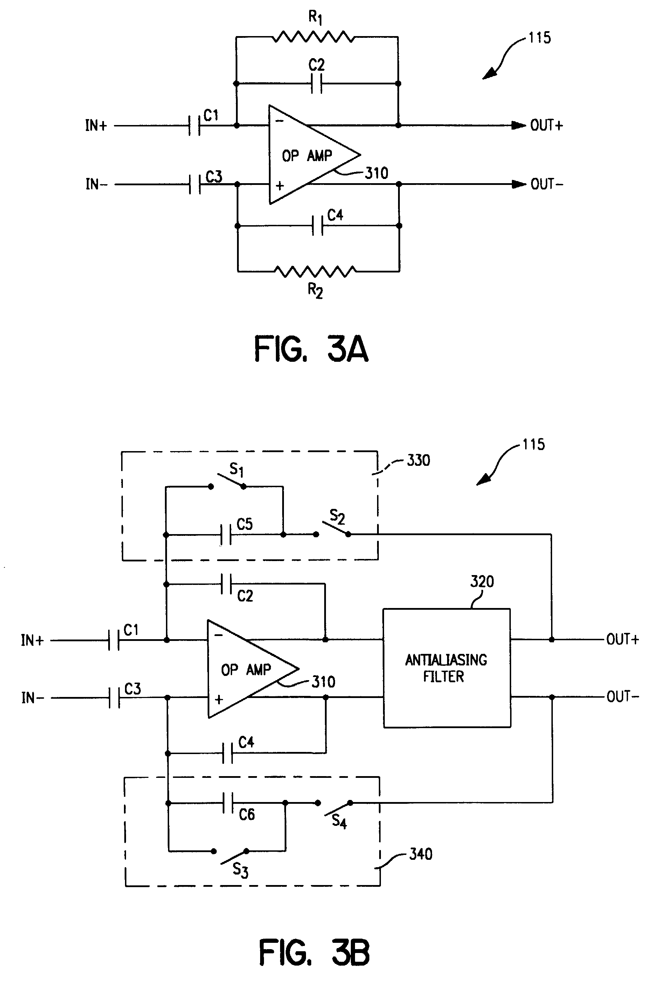

Referring to Figure 3(A), a circuit diagram illustrating one embodiment of the amplifier 115 is shown. The amplifier 115 consists of op amp 310, capacitors C1, C2, C3, and C4, resistors R1 and R2. The inputs to the amplifier 115 are IN+ and IN-. The outputs of the amplifier 115 are OUT+ and OUT-. In this embodiment, a differential approach is shown. A single-ended approach can be similarly designed.

To avoid large resistor values for low frequency filter poles, the present invention simulates resistors by a switched capacitor technique.

Referring to Figure 3(B), a circuit diagram illustrating one embodiment of the switched-capacitor design. The amplifier 115 consists of op amp 310, capacitors C1, C2, C3, and C4, Resistors R1 and R2 are replaced by the switched capacitor resistors 330 and 340, respectively. Switched capacitor 330 consists of switches S1 and S2 and capacitor C5. Switch capacitor 340 consists of switches S3 and S4 and capacitor C6. These two switched-capacitor resistors provide DC feedback to the op amp 310. The anti-aliasing filter 320 is used to reduce aliasing distortion.

The output signal of the anti-aliasing filter 320 goes to the analog transceiver 135 to be stored in the storage array 150. The analog transceiver 135 also provides the reading or retrieving of the stored analog signals in the storage array 150 for outputting to the output amplifier 145 through the smoothing filter 140.

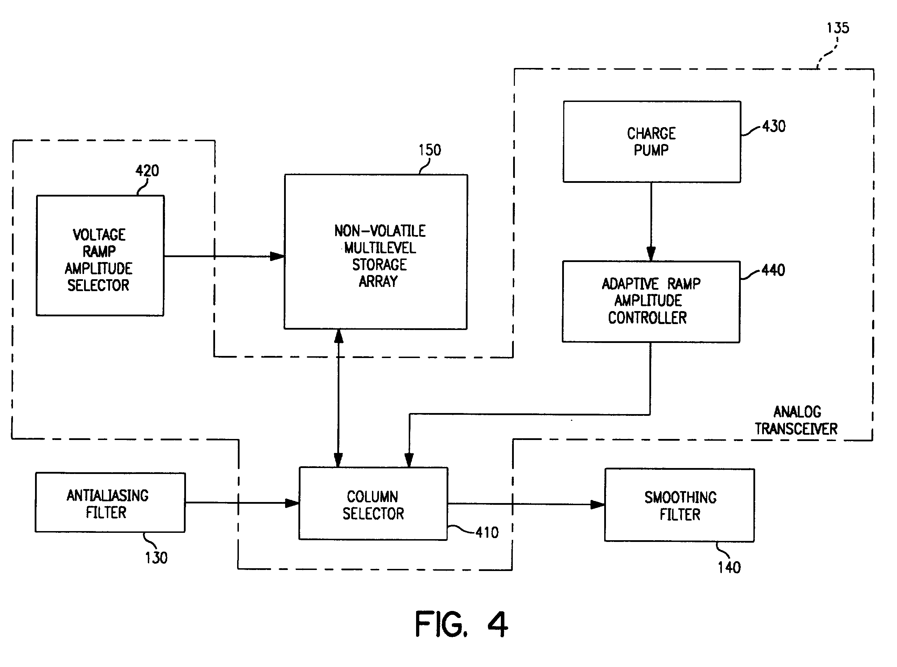

Referring to Figure 4, a block diagram of one embodiment of the analog transceiver 135 is shown. The analog transceiver 135 comprises a column selector 410, a voltage ramp amplitude selector 420, a charge pump 430, and an adaptive ramp amplitude controller 440.

The column selector 410 selects the column in the storage array 150 for storing the analog signal or for reading the stored analog signal. The column selector 410 is coupled to the anti-aliasing filter 130 and the smoothing filter 140. During recording, the column selector provides a signal path between the anti-aliasing filter 130 and the storage array 150. During playback, the column selector provides a signal path between the storage array 150 and the smoothing filter 140. The anti-aliasing filter 130 and the smoothing filter 140 may correspond to the same filter element. The conditioned signal from the anti-aliasing filter 130 is adjusted to the appropriate voltage range to be stored in the non-volatile multilevel storage array 150.

The voltage ramp amplitude selector 420 selects an appropriate voltage ramp amplitude to adjust the programming of the non-volatile memory cells in the storage array 150. The charge pump 430 generates an appropriate high voltage level for clearing and programming the memory cells. The adaptive ramp amplitude controller 440 regulates the voltage applied to the memory cells.

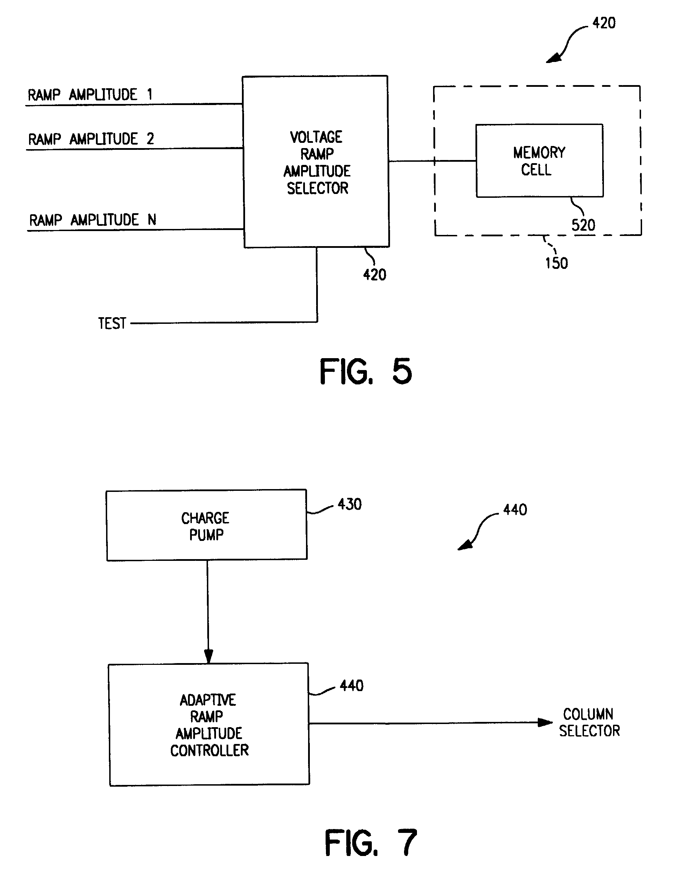

Referring to Figure 5, a block diagram illustrating one embodiment of the voltage ramp amplitude selector 420 is shown. The voltage ramp amplitude selector 420 provides a way to adjust the programming of the non-volatile memory cells. The voltage ramp amplitude selector 420 comprises a selector 510 and the corresponding memory cell 520 in the storage array 150.

The selector 510 selects one of several preset voltage ramp amplitudes 1 through N. The selection can be performed by a group of memory cells which can be changed at testing. The selector 510 provides an accurate means to adjust the programming voltage. It also improves the wide margin for multilevel storage cells.

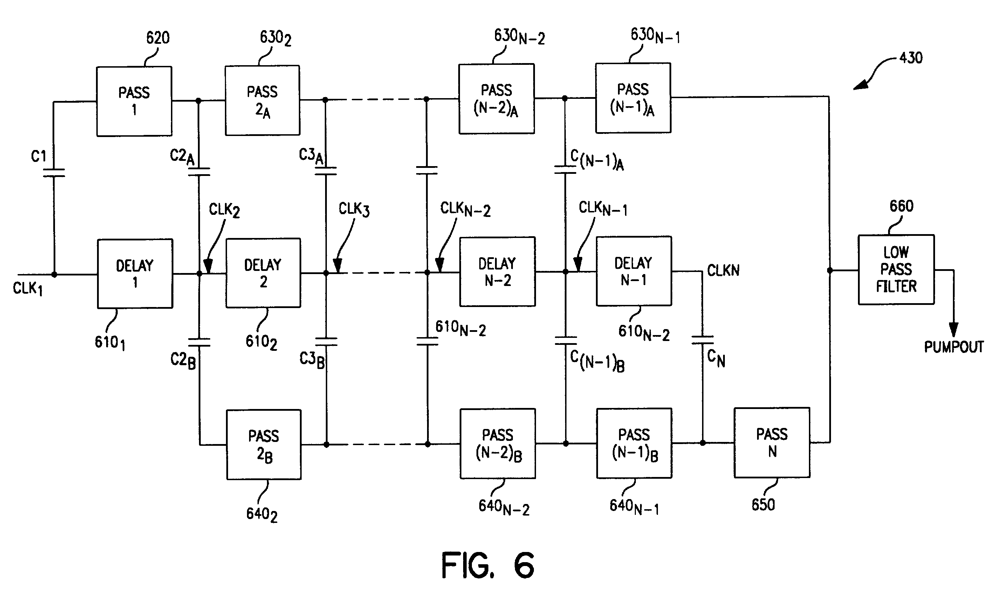

Referring to Figure 6, a block diagram illustrating one embodiment of a circuit to generate the charge pump is shown. The circuit shown in Figure 6 provides improved performance by reducing the power supply spikes and circuit area. The charge pump circuit 430 consists of DELAY1 610₁ through DELAY N-1 610(N-1), PASS 1 620, PASS 2A 6302 through PASS (N-1) 630_{N-1}, PASS 2B 640₂ through PASS (N-1) 640_{N-1}, PASS N 650, capacitors C1, CᵢA (i=2 to N-1), CjB (j=2 to N-1), C_{N}, and low pass filter 660.

DELAY 1 6101 through DELAY N-1 610_{N-1} delay the clock signal by an appropriate time. With the delay clock line, only one source is needed. Each clock delay driver drives at most two capacitors and the next delay stage. Since the load for each clock is small, being proportional to 2C where C is the capacitors in the delay line, the current surge on the power supply is small and is distributed over the chain of delay line.

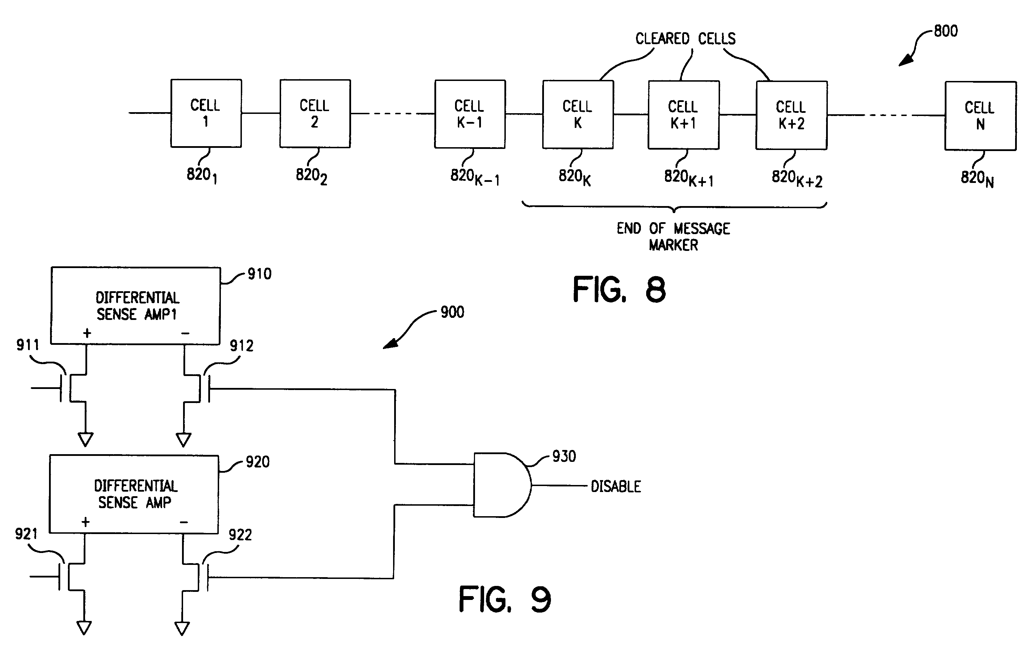

Referring to Figure 7, a block diagram illustrating one embodiment of the adaptive ramp amplitude controller 440 is shown. The adaptive ramp amplitude controller 440 is coupled to the charge pump 430 and the column selector 410 as shown in Figure 4. The charge pump 430 provides the programming and the erasing voltages. The controller 440 regulates how fast and how high the voltage is applied to the non-volatile memory cell. This process erases and programs the memory cells. Since the programming voltage applied to the memory cell is a ramp function, many different voltage levels within the programming voltage range can be stored. It is not limited to discrete levels. The circuit reduces the circuit complexity, saves area, and improve reliability.

Charge pump 430 provides a constant voltage source for programming and erasing the memory cell. The controller 440 generates the high voltage ramp by only one coarse and two fine ramp pulses. The controller 440, however, can generate the high voltage ramp by any combination of coarse and fine ramp pulses. The column selector 410 controls the flow of the signals and selects the appropriate column on the non-volatile memory array.

The playback of the message is terminated with either an end of message (EOM) marker or the end of the non-volatile storage array. Referring to Figure 8, a block diagram illustrating one embodiment of the end of message marker is shown. The end of message (EOM) marker 800 consists of a number of cleared cells in N memory cells 820₁ through 820_{N}.

The EOM marking is implemented by detecting three consecutive cleared cells CELL K, CELL K+1 and CELL K+2. Three consecutive fully cleared cells ensure that the EOM is reliably identified because the probability that three consecutive cells are cleared by defects is extremely low.

Referring to Figure 9, a circuit diagram illustrating one embodiment of a disabling controller 900 that enables disabling of failed devices. The disabling controller 900 consists of differential sense amplifiers 910 and 920, four nonvolatile cells 911, 912, 921 and 922, and AND gate 930. During testing, if the device fails specifications, the four cells 911, 912, 921 and 922 will be programmed accordingly and the disabling output is asserted to prevent the device from powering up.

This circuit reduces the customer return rate because the failed device is identified easily.

Other improvements help reducing area, pin-outs and minimizing noise. For example, separate supply power and ground inputs for analog and digital circuits are provided through separate power buses. The user also has a means for knowing wen the message is ended by monitoring the output signal on RECLED* pin. This signal momentarily pulses low and the device powers down.

While certain exemplary embodiments have been described and shown in the accompanying drawings, it is to be understood that such embodiments are merely illustrative of and not restrictive on the broad invention, and that this invention not be limited to the specific constructions and arrangements shown and described, since various other modifications may occur to those ordinarily skilled in the art.

## Claims

1. An integrated circuit for processing an audio signal of a message, the integrated circuit comprising:
a record circuit coupled to receive the audio signal, the record circuit generating an AC-coupled filtered signal;
an analog storage circuit coupled to said record circuit for storing said filtered signal; and
a playback circuit coupled to said analog storage circuit for retrieving a stored signal in said storage circuit.

2. An integrated circuit for processing an audio signal of a message, the integrated circuit comprising:
a record circuit coupled to receive the audio signal, the record circuit generating a filtered signal;
an analog storage circuit coupled to said record circuit for storing said filtered signal; and
a playback circuit AC-coupled to said analog storage circuit for retrieving a stored signal in said storage circuit.

3. An integrated circuit for processing an audio signal of a message, the integrated circuit comprising:
a record circuit coupled to receive the audio signal, the record circuit generating an AC-coupled filtered signal;
an analog storage circuit coupled to said record circuit for storing said filtered signal; and
a playback circuit AC-coupled to said analog storage circuit for retrieving a stored signal in said storage circuit.

4. The integrated circuit of claim 1,2, or 3 further comprises a control circuit for providing control functions.

5. The integrated circuit of claim 1, 2, or 3 further comprises a clock generator for generating timing signals to control writing and reading of said storage array.

6. The integrated circuit of claim 1 or 3 wherein the record circuit comprises:
a first amplifier to pre-amplify the audio signal, the first amplifier having a variable gain;
a second amplifier AC-coupled to the first amplifier for providing an amplified signal;
an automatic gain control (AGC) circuit coupled to the second amplifier for providing a control voltage to adjust the variable gain; and
an anti-aliasing filter coupled to the second amplifier for providing the filtered signal.

7. The integrated circuit of claim 1, 2, or 3 wherein the analog storage circuit comprises:
a storage array having a plurality of non-volatile memory cells; and
an analog transceiver coupled to said storage array for controlling storing the filtered signal and retrieving the stored signal.

8. The integrated circuit of claim 7 wherein the analog transceiver comprises:
a column selector coupled to receive the filtered signal, the column selector selecting a column in the storage array for storing the filtered signal and for retrieving the stored signal;
an adaptive ramp amplitude controller coupled to said column selector for controlling an application of a programming voltage to the storage array, said programming voltage being used to write to the plurality of non-volatile memory cells in storing the filtered signal;
a charge pump coupled to said adaptive ramp amplitude controller for generating said programming voltage; and
a ramp amplitude selector coupled to the storage array for selecting a comparing voltage in adjusting said programming voltage.

9. The integrated circuit of claim 1,2, or 3 wherein the playback circuit comprises:
a smoothing filter for smoothing the stored signal retrieved from said analog storage circuit to produce a smoothed signal; and
an output amplifier coupled to said smoothing filter for amplifying said smoothed signal to produce an amplified output signal.

10. The integrated circuit of claim 5 wherein said timing signals control a recording duration by varying a first resistor value and a playback duration by varying a second resistor value.

11. The integrated circuit of claim 4 wherein the control functions include a recording function, a playback function, and an end-of-message (EOM) function.

12. The integrated circuit of claim 11 wherein said EOM function is realized by detecting at least three consecutive cleared cells in said storage array.

13. A record circuit for recording an audio signal of a message by generating a filtered signal to be stored in a storage array, the record circuit comprising:
a first amplifier to pre-amplify the audio signal, the first amplifier having a variable gain;
a second amplifier AC-coupled to the first amplifier for providing an amplified signal;
an automatic gain control (AGC) circuit coupled to the second amplifier for providing a control voltage to adjust the variable gain; and
an anti-aliasing filter coupled to the second amplifier for providing the filtered signal.

14. An analog storage circuit for storing an analog signal from a record circuit and for retrieving a stored signal, the record circuit being AC-coupled to the analog storage circuit, the analog storage circuit comprising:
a storage array having a plurality of non-volatile memory cells; and
an analog transceiver coupled to said storage array for controlling storing said analog signal and retrieving said stored signal.

15. The analog storage circuit of claim 14 wherein the analog transceiver comprises:
a column selector coupled to receive the analog signal, the column selector selecting a column in the storage array for storing the analog signal and for retrieving the stored signal;
an adaptive ramp amplitude controller coupled to said column selector for controlling an application of a programming voltage to the storage array, said programming voltage being used to write to the plurality of non-volatile memory cells in storing the analog signal;
a charge pump coupled to said adaptive ramp amplitude controller for generating said programming voltage; and
a ramp amplitude selector coupled to the storage array for selecting a comparing voltage in adjusting said programming voltage.

16. A playback circuit for retrieving a stored signal in an analog storage circuit, the analog storage circuit being AC-coupled to the playback circuit, the playback circuit comprising:
a smoothing filter for smoothing the stored signal retrieved from said analog storage circuit to produce a smoothed signal; and
an output amplifier coupled to said smoothing filter for amplifying said smoothed signal to produce an amplified output signal.
